# EUROPEAN PATENT SPECIFICATION

(11) **EP 0 456 231 B1**
(45) Date of publication and mention of the grant of the patent: **08.01.1997**
(21) Application number: 91107532.3
(22) Date of filing: 08.05.1991
(51) Int. Cl.: H03K 5/13

(54) **Programmable delay circuit**
Programmierbare Verzögerungsschaltung
Circuit de retard programmable

(30) Priority: 11.05.1990 JP 119792/90
(43) Date of publication of application: 13.11.1991
(73) Proprietor: SONY CORPORATION, Tokyo (JP)
(72) Inventor: Murakami, Daisuke, c/o SONY CORPORATION, Shinagawa-ku, Tokyo (JP)
(74) Representative: TER MEER - MÜLLER - STEINMEISTER & PARTNER

(56) References cited:
- EP-A- 0 317 758
- EP-A- 0 347 983
- US-A- 4 675 562
- U.Tietze and Ch.Schenk, "Halbleiter-Schaltungstechnik", sixth edition, 1983, Springer-Verlag, Berlin, pages 728-731

## Description

### FIELD OF THE INVENTION

The present invention relates to a programmable delay circuit according to the precharacterizing part of claim 1. Such a programmable delay circuit is known from US-A-4,675,562, or from EP-A-0 317 758.

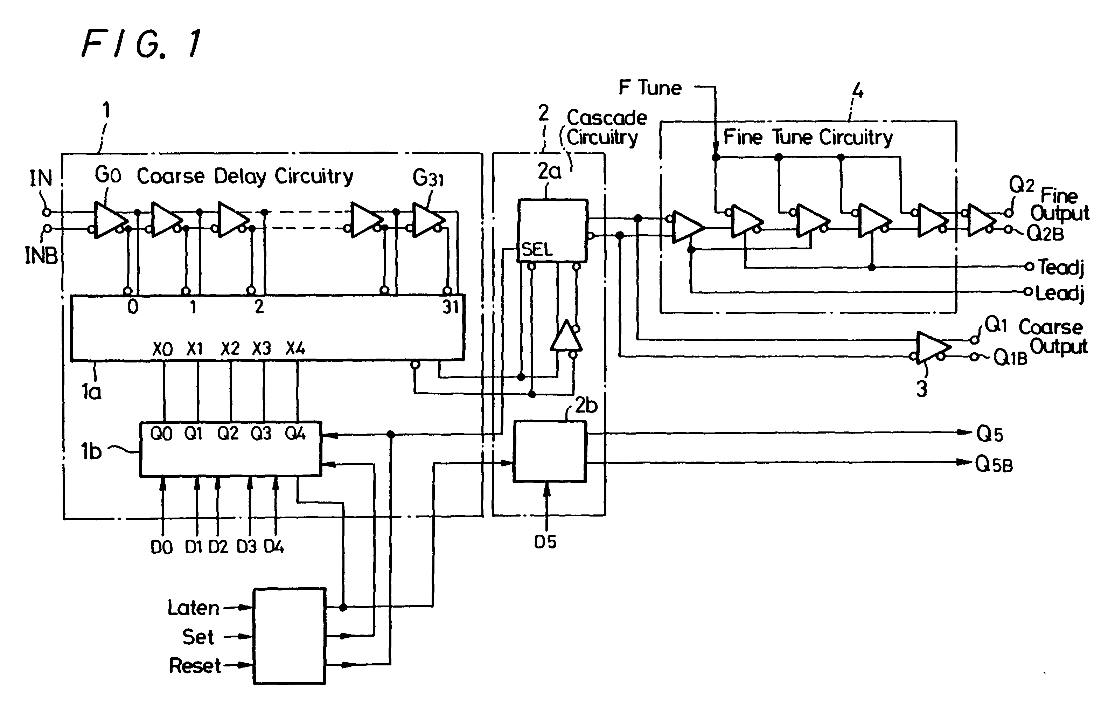

"A Digitally Programmable Delay Chip with picosecond Resolution" described in IEEE Proceedings of the 1989 Bipolar Circuit and Technology Meetings, September 18-19, 1989, pp. 295 to 297 forms a further conventional programmable delay circuit. A block diagram forming Fig. 1 shows an example of such a conventional programmable delay circuit.
As shown in Fig. 1, a main or coarse delay circuit 1 is composed of 32 delay gates G₀ to G₃₁ connected in cascade, a multiplexer 1a and a latch circuit 1b. The latch circuit 1b latches a digital signal of 5 bits (D₀ to D₄) input thereto from a control circuit (not shown) and the multiplexer 1a is controlled in response to the digital output of the latch circuit 1b, thereby pulse signals applied to input terminals IN and INB being delayed by an arbitrary delay time of 110 picoseconds per gate. a cascade circuit 2 is connected to an output of the multiplexer 1a to expand the delay time and composed of a multiplexer 2a and a latch circuit 2b which latches a digital signal D₅. An output of the cascade circuit 2 is supplied through a buffer stage 3 to output terminals A1 and Q1B,respectively, and a sub or fine tune circuitry 4 is connected to the output of the cascade circuit 2.

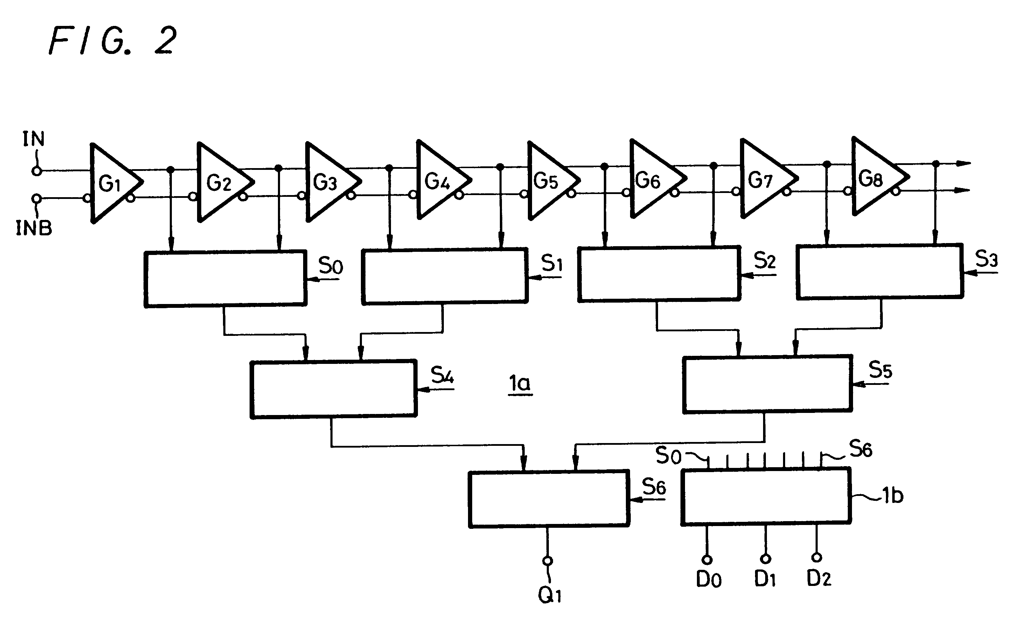

Fig. 2 is a schematic block diagram showing an example of a conventional multiplexer, and as shown in Fig. 2, the multiplexer 1a of Fig. 1 is generally comprised of 8 stages of delay gates G₁ to G₈ and seven multiplexers A through G which are supplied with control signals S₀ to S₆ delivered from the latch circuit 1b.

However, in the conventional delay circuit of Fig. 2, the multiplexer 1a is composed of seven multiplexers A through G connected in a so-called tournament fashion, which needs 2ⁿ-1 multiplexer stages if there are provided 2ⁿ-1 delay circuits. Further, since the signal is passed through n multiplexers from each of the delay gates to the output terminal Q₁, the fixed delay time is increased. In that case, if n is increased, the delay error caused by the multiplexer 1a from each of the delay gates to the output terminal Q₁ is increased, thus deteriorating linearity of delay characteristic more. Furthermore, since the pulse signals supplied to the input terminals IN and INB are passed through the n multiplexers (e.g., the multiplexers A, E and G), the power consumption is increased.

U. Tietze & Ch. Schenk, "Halbleiter-Schaltungstechnik", 1983, Springer Verlag, Berlin, Heidelberg, New York, Tokyo; pages 728-731 discloses a broad band multiplexer including differential amplifier stages and current switches for selectively providing a drive current from a common current source to a selected pair to the transistors of a differential amplifier according to a logic selection signal.

The programmable delay circuit disclosed in US-A-4,675,562 is composed of fine and coarse delay sections, each section comprising a plurality of delay stages, which are either serial-connected differential delay lines or cascaded gates. As is shown in Fig.3 of US-A-4 675 562, the first two delay sections include differential multiplexers, each multiplexer stage including a differential transistor amplifier, wherein each stage of the multiplexer is respectively coupled with an input or output of a corresponding delay line stage. The stages of the multiplexer are selected by a selection circuit comprising transistors, each of said transistors being respectively coupled to connected emitter terminals of the differental amplifiers of each multiplexer stage, said transistors selectively supplying current from a single current source to select each stage of the multiplexer. An ordinary emitter follower output amplifier supplies the output signals of the known delay circuit. Further the output signals of the programmable coarse delay circuit shown in Fig 5 of US-A-4,675,562 are derived from the output of a logical AND gate.

### SUMMARY OF THE INVENTION

It is an object of the present invention to provide a programmable delay circuit in which linearity of delay characteristic can be improved, in which power consumption can be reduced, which can be operated at high speed and which can produce satisfactory delay characteristic.

According to an essential aspect of the present invention, a programmable delay circuit solving the above object comprises:
a) differential input terminals to which an input signal to be delayed is supplied;
b) n delay circuits of a plurality of stages connected in cascade, where n ≥ 2;
c) a differential multiplexer consisting of a plurality of first differential amplifiers respectively connected to said plurality of stages of delay circuits, each first differential amplifier having a pair of transistors,
d) differential output terminals to which respective output terminals of said pair of transistors of said plurality of first differential amplifiers of said multiplexer are commonly connected; wherein
e) each first differential amplifier of said multiplexer is further connected to a respective one of a plurality of current switches for selectively supplying a drive current from a common current source to a respective one of said first differential amplifiers of said multiplexer when the respective one of said current switches is selected by a control circuit for selectively ON-OFF controlling said current switches, and a buffer stage is connected in cascade between said differential output terminals and output terminals of said programmable delay circuit,
characterized in that
- each of said delay circuits of said plurality of stages is formed of an emitter follower circuit and a second differential amplifier, said second differential amplifier being connected to emitter terminals of said emitter follower circuit,
- each of said plurality of first differential amplifiers of said multiplexer is respectively connected to respective said emitter terminals;and
- said buffer stage is configured so as to reduce the apparent output capacitances of the transistors of said first differential amplifiers.

According to the programmable delay circuit of the present invention, even when any one of the current switches of the plurality of differential amplifiers is selected, delay amounts of the differential amplifiers become constant so that linearity of delay characteristic can be improved. Also, since the single common current source is employed, the power consumption can be reduced.

Further, when the buffer stages connected in cascade are provided between the outputs of said plurality of differential amplifiers and said common output terminal, the output capacitances of the differential amplifier transistors can be apparently reduced and thus the programmable delay circuit of the present invention can be operated at high speed.

The above, and other objects, features and advantages of the present invention will become apparent from the following detailed description of illustrative embodiments thereof to be taken in conjunction with the accompanying drawings.

### BRIEF DESCRIPTION OF THE DRAWINGS

Fig. 1 is a block diagram showing an example of a conventional programmable delay circuit;
Fig. 2 is a block diagram showing an example of a multiplexer used in the conventional programmable delay circuit of Fig. 1;
Fig. 3 is a block circuit diagram showing a fundamental arrangement of a programmable delay circuit; and
Fig. 4 (formed of Fig. 4A and 4B) is a circuit diagram showing an embodiment of the programmable delay circuit according to the present invention.

### DESCRIPTION OF THE PREFERRED EMBODIMENTS

The present invention will now be described with reference to the drawings.

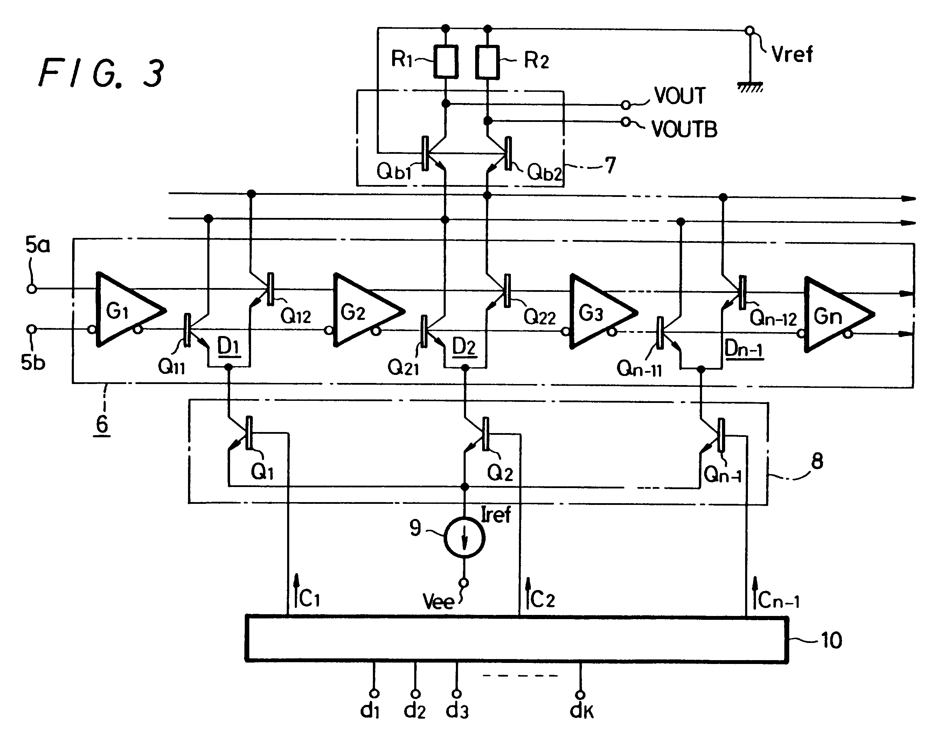

Fig. 3 shows in block circuit form a fundamental arrangement of the programmable delay circuit which is in said block circuit form not subject matter of the claimed invention. Referring to Fig. 3, input signals (pulse signals such as clock signals or the like) to be delayed are supplied to input terminals 5a and 5b of a delay circuit 6 and, by way of example, these input signals are opposite in phase. The delay circuit 6 has N stages (N ≧ 2) and composed of a plurality of delay circuits (G₁ through Gₙ) which are connected in cascade. Input electrodes (bases) of a pair of differential amplifier transistors Q₁₁ and Q₁₂ are connected between the first and second delay circuits G₁ and G₂ of the delay circuit 6. Output electrodes (collectors) of the transistors Q₁₁ and Q₁₂ are connected through transistors Q_{b1} and Q_{b2} which constitute a buffer stage 7 and connected in cascade to common output terminals VOUT and VOUTB, respectively. Incidentally, load resistors R₁ and R₂ are connected between a reference voltage source V_{ref} (by way of example, ground potential) and the common output terminals VOUT and VOUTB, respectively. A current switch 8 is composed of transistors Q₁ to Qₙ₋₁, and a common current source 9 has a current value of, for example, I_{ref}. The differential amplifier transistors Q₁₁ and Q₁₂ and the transistor Q₁ of the current switch 8 constitute a first differential amplifier D₁; differential amplifier transistors Q₂₁ and Q₂₂ connected between the second and third delay circuits G₂ and G₃ and a transistor Q₂ of the current switch 8 constitute a second differential amplifier D₂; and differential amplifier transistors Qₙ₋₁₁ and Qₙ₋₁₂ connected between the third delay circuit G₃ and an N'th delay circuit Gₙ and a transistor Qₙ₋₁ of the current switch 8 constitute a (N-1)'th differential amplifier Dₙ₋₁. In Fig. 3, reference numeral 10 designates a control circuit which selectively controls the current switch 8. For example, the control circuit 10 controls the transistors Q₁ to Qₙ₋₁ of the current switch 8 in response to, for example, digital signals d₁ to dₖ of K bits.

Operation of the thus constructed programmable delay circuit will be described below.

Referring to Fig. 3, when, for example, the transistor Q₁ of the current switch 8 is selected by the digital signals d₁ to dₖ of the control circuit 10, the transistor Q₁ is turned on to permit the current I_{ref} of the common current source 9 to be supplied to the differential amplifier transistors Q₁₁ and Q₁₂ of the first differential amplifier D₁ so that the input signals applied to the input terminals 5a and 5b are supplied to the first delay circuit G₁. An output of the first delay circuit G₁ is amplified by the first differential amplifier D₁ and supplied through the buffer stage 7 to the common output terminals VOUT and VOUTB. Similarly, when the transistor Q₂ of the current switch 8 is selected, the transistor Q₂ is turned on to permit the current I_{ref} of the common current source 9 to be supplied to the differential amplifier transistors Q₂₁ and Q₂₂ of the second differential amplifier D₂ so that the input signals applied to the input terminals 5a and 5b are supplied to the second delay circuit G₂. An output of the second delay circuit G₂ is amplified by the second differential amplifier D₂ and supplied through the buffer stage 7 to the common output terminals VOUT and VOUTB. That is, the current switch 8 of the plurality of differential amplifiers D₁ to Dₙ₋₁ is controlled by the control signals C₁ to Cₙ₋₁ of the control circuit 10, whereby the outputs of the 2ⁿ⁻¹ (N-1)'th delay circuits G₁ to Gₙ₋₁ can be selectively output. Even when any of the transistors Q₁ to Qₙ₋₁ of the current switch 8 of the plurality of differential amplifiers D₁ to Dₙ₋₁ is selected, the delay times of the differential amplifiers D₁ to Dₙ₋₁ are constant and the fixed delay times are reduced so that linearity of delay characteristic can be improved. Also, since the single common current source 9 is used, the power consumption can be reduced.

Further, when the cascade-connected buffer stage 7 is connected between the outputs of the plurality of differential amplifiers D₁ to Dₙ₋₁ and the common output terminals VOUT and VOUTB, the output capacitances of the differential amplifier transistors Q₁₁ to Qₙ₋₁₂ are apparently reduced, thereby the programmable delay circuit of the invention being operated at high speed.
Incidentally, the delay time can be further increased by providing other differential amplifiers (not shown) in the output of the N'th delay circuit Gₙ.

Alternatively, though not shown, it is possible to provide a differential amplifier which supplies the input signals applied to the input terminals 5a and 5b directly to the common output terminals VOUT and VOUTB (the first delay circuit G₁ is bypassed).

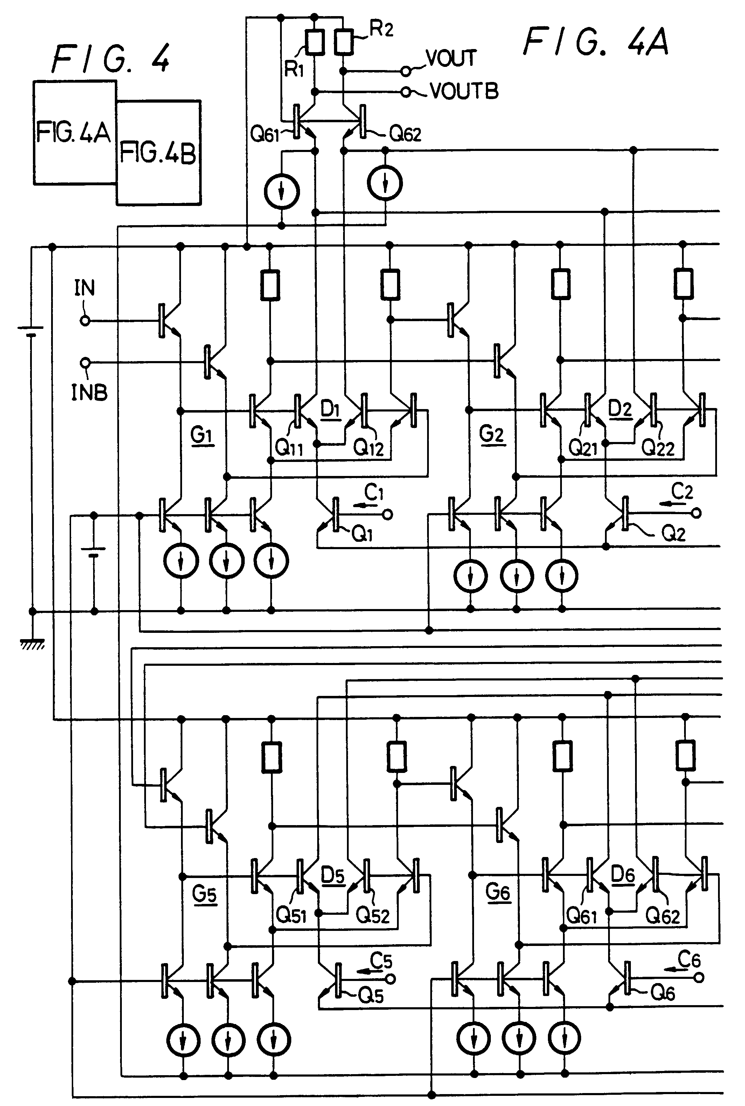

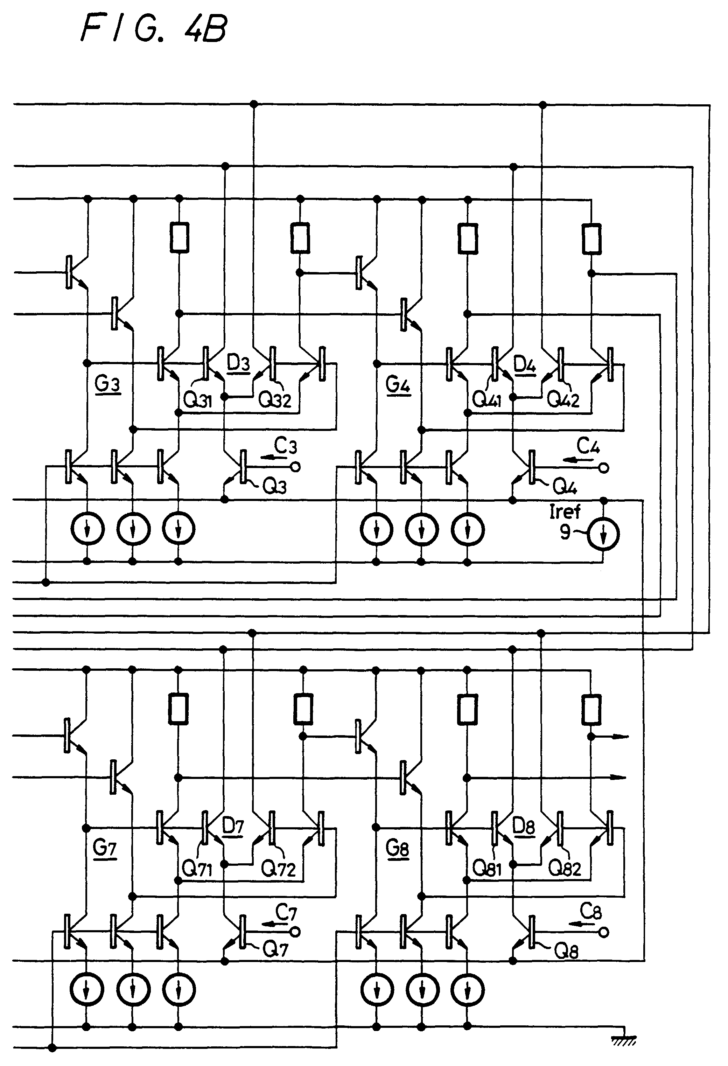

A specific circuit arrangement of the embodiment of the programmable delay circuit according to the present invention will be described with reference to Fig. 4. Fig. 4 is formed of Fig. 4A and 4B drawn on two sheets of drawings so as to permit the use of a suitably large scale. Some of the principles explained above with reference to Fig. 3 are valid also for the circuit shown in Fig. 4.

In Fig. 4, like parts corresponding to those of Fig. 3 are marked with the same references and therefore need not be described in detail.

As shown in Fig. 4, the delay circuit 6 of Fig. 3 is composed of eight stages of first delay circuit G₁ to eighth delay circuit G₈ and each of the first to eighth delay circuits G₁ to G₈ is formed of an emitter-follower circuit and a differential amplifier. The transistors Q₁ to Q₈ constructing the current switch 8 of the first to eighth differential amplifiers D₁ to D₈ are controlled by control signals C₁ to C₈ from a control circuit (not shown). In the embodiment of Fig. 4, if the delay time of each delay circuit is selected to be, for example, 100 psec, the delay time can be varied in a range of from 100 psec to 800 psec (e.g., 10 nsec in the case of 2ⁿ = 128), thus achieving similar effects to those of Fig. 3.

Further, in this embodiment, since the input pulse signal is transmitted in a push-pull fashion, there is then the advantage that the duty ratio of the input pulse signal can be maintained constant until it is output.

As will be clear from the above explanation, according to the programmable delay circuit of the present invention, even when any one of the current switches of the plurality of differential amplifiers is selected, the delay amounts of the differential amplifiers become constant so that the linearity of the delay characteristic can be improved. Also, since the single common current source is employed, the power consumption can be reduced.

When the cascade-connected buffer stage is provided between the outputs of the plurality of differential amplifiers and the common output terminal, the output capacitances of the differential amplifier transistors can be apparently reduced so that the programmable delay circuit of the present invention can be operated at higher speed.

Furthermore, according to the programmable delay circuit of the present invention, even when the number of stages of the delay circuit is increased, delay errors of the multiplexer can be prevented from being accumulated unlike the example of the prior art, thus making it possible to obtain satisfactory delay characteristic.

## Claims

1. A programmable delay circuit comprising:
a) differential input terminals (5a, 5b) to which an input signal to be delayed is supplied;
b) n delay circuits (G₁-Gₙ) of a plurality of stages connected in cascade, where n ≥ 2;
c) a differential multiplexer consisting of a plurality of first differential amplifiers (D1-Dₙ₋₁) respectively connected to said plurality of stages of delay circuits, each first differential amplifier having a pair of transistors (Q₁₁, Q₁₂; Qₙ₋₁₁, Qₙ₋₁₂),
d) differential output terminals to which respective output terminals of said pair of transistors of said plurality of first differential amplifiers of said multiplexer are commonly connected; wherein
e) each first differential amplifier (D₁-Dₙ₋₁) of said multiplexer is further connected to a respective one of a plurality of current switches (Q₁-Qₙ₋₁) for selectively supplying a drive current from a common current source (9) to a respective one of said first differential amplifiers (D₁-Dₙ₋₁) of said multiplexer when the respective one of said current switches (Q₁-Qₙ₋₁) is selected by a control circuit (10) for selectively ON-OFF controlling said current switches (Q₁-Qₙ₋₁), and a buffer stage is connected in cascade between said differential output terminals and output terminals (Vₒᵤₜ, V_{outB}) of said programmable delay circuit,
**characterized in that**
- each of said delay circuits (G1-Gn) of said plurality of stages is formed of an emitter follower circuit and a second differential amplifier, said second differential amplifier being connected to emitter terminals of said emitter follower circuit,
- each of said plurality of first differential amplifiers (D₁-Dₙ₋₁) of said multiplexer is respectively connected to respective said emitter terminals;and
- said buffer stage (7) is configured so as to reduce the apparent output capacitances of the transistors of said first differential amplifiers.

2. The programmable delay circuit according to claim 1, wherein a complementary signal is supplied to said input terminals to which the input signal to be delayed is supplied and a complementary signal delayed by a delay time determined by the selection of one of the current switches is derived from said output terminals.

## Patentansprüche

1. Programmierbare Verzögerungsschaltung mit:
a) Differenzeingangsanschlüssen (5a, 5b), an die ein zu verzögerndes Eingangssignal geliefert wird;
b) n Verzögerungsschaltungen (G₁ - Gₙ) mit mehreren kaskadenförmig geschalteten Stufen mit n ≥ 2;
c) einem Differenzmultiplexer, der aus mehreren ersten Differenzverstärkern (D1 - Dₙ₋₁) besteht, die jeweils mit den mehreren Stufen von Verzögerungsschaltungen verbunden sind, wobei jeder erste Differenzverstärker ein Paar Transistoren (Q₁₁, Q₁₂; Qₙ₋₁₁, Qₙ₋₁₂) aufweist;
d) Differenzausgangsanschlüssen, mit denen jeweilige Ausgangsanschlüsse des Paars Transistoren der mehreren ersten Differenzverstärker des Multiplexers gemeinsam verbunden sind;
e) wobei jeder erste Differenzverstärker (D₁ - Dₙ₋₁) des Multiplexers ferner mit einem jeweiligen unter mehreren Stromschaltern (Q₁ - Qₙ₋₁) verbunden ist, um selektiv einen Treiberstrom von einer gemeinsamen Stromquelle (9) an einen jeweiligen der ersten Differenzverstärker (D₁ - Dₙ₋₁) des Multiplexers zu liefern, wenn der jeweilige der Stromschalter (Q₁ - Qₙ₋₁) durch ein Steuersignal (10) zur selektiven EIN-AUS-Steuerung der Stromschalter (Q₁ - Qₙ₋₁) ausgewählt wird, und wobei eine Pufferstufe kaskadenförmig zwischen die Differenzausgangsanschlüsse und die Ausgangsanschlüsse (V_{OUT}, V_{OUTB}) der programmierbaren Verzögerungsschaltung geschaltet ist;
**dadurch gekennzeichnet,** dass
- jede der Verzögerungsschaltungen (G1 - Gn) der mehreren Stufen aus einer Emitterfolgerschaltung und einem zweiten Differenzverstärker besteht, wobei dieser zweite Differenzverstärker mit den Emitteranschlüssen der Emitterfolgerschaltung verbunden ist;
- jeder der mehreren ersten Differenzverstärker (D₁ - Dₙ₋₁) des Multiplexers jeweils mit einem jeweiligen der Emitteranschlüsse verbunden ist; und
- die Pufferstufe (7) so aufgebaut ist, dass sie die scheinbaren Ausgangskapazitäten der Transistoren der ersten Differenzverstärker verringert.

2. Programmierbare Verzögerungsschaltung nach Anspruch 1, bei der den Eingangsanschlüssen, denen das zu verzögernde Eingangssignal zugeführt wird, ein komplementäres Signal zugeführt wird und von den Ausgangsanschlüssen ein komplementäres Signal abgeleitet wird, das um eine Verzögerungszeit verzögert ist, die durch die Auswahl eines der Stromschalter bestimmt ist.

## Revendications

1. Circuit à retard programmable comprenant :
a) des bornes d'entrée différentielles (5a, 5b) auxquelles un signal d'entrée à retarder est appliqué ;
b) n circuits à retard (G₁ à Gₙ) d'une pluralité d'étages montés en cascade, où n ≥ 2 ;
c) un multiplexeur différentiel se composant d'une pluralité de premiers amplificateurs différentiels (D₁ à Dₙ₋₁) raccordés respectivement à ladite pluralité d'étages de circuits à retard, chaque premier amplificateur différentiel ayant une paire de transistors (Q₁₁, Q₁₂ ; Qₙ₋₁₁, Qₙ₋₁₂),
d) des bornes de sortie différentielles auxquelles des bornes de sortie respectives de ladite paire de transistors de ladite pluralité de premiers amplificateurs différentiels dudit multiplexeur sont raccordées communément ; dans lequel
e) chaque premier amplificateur différentiel (D₁ à Dₙ₋₁) dudit multiplexeur est en outre raccordé à un commutateur respectif d'une pluralité de commutateurs de courant (Q₁ à Qₙ₋₁) pour fournir sélectivement un courant de commande à partir d'une source de courant commune (9) à un amplificateur respectif desdits premiers amplificateurs différentiels (D₁ à Dₙ₋₁) dudit multiplexeur lorsqu'un commutateur respectif desdits commutateurs de courant (Q₁ à Qₙ₋₁) est sélectionné par un circuit de commande (10) pour commander sélectivement en conducteur - bloqué lesdits commutateurs de courant (Q₁ à Qₙ₋₁), et un étage tampon est monté en cascade entre lesdites bornes de sortie différentielles et des bornes de sortie (Vₒᵤₜ, V_{outB}) dudit circuit à retard programmable,
caractérisé en ce que
- chacun desdits circuits à retard (G₁ à Gₙ) de ladite pluralité d'étages est formé d'un circuit émetteur suiveur et d'un second amplificateur différentiel, ledit second amplificateur différentiel étant raccordé aux bornes d'émetteur dudit circuit émetteur suiveur,
- chaque amplificateur de ladite pluralité de premiers amplificateurs différentiels (D₁ à Dₙ₋₁) dudit multiplexeur est raccordé respectivement auxdites bornes d'émetteur ; et
- ledit étage tampon (7) est configuré afin de réduire les capacités de sortie apparentes des transistors desdits premiers amplificateurs différentiels.

2. Circuit à retard programmable selon la revendication 1, dans lequel un signal complémentaire est fourni auxdites bornes d'entrée auxquelles le signal d'entrée à retarder est appliqué et un signal complémentaire retardé par un retard déterminé par la sélection d'un des commutateurs actuels est dérivé à partir desdites bornes de sortie.
